Europäisches Patentamt

European Patent Office

Office européen des brevets

(19)

(11) Publication number: **0 164 570**
**A2**

(12) # EUROPEAN PATENT APPLICATION

(21) Application number: **85105596.2**

(22) Date of filing: **07.05.85**

(51) Int. Cl.⁴: **G 01 R 31/02**

(30) Priority: **11.05.84 JP 94229/84**
**11.05.84 JP 94232/84**

(43) Date of publication of application:
**18.12.85 Bulletin 85/51**

(84) Designated Contracting States:
**DE FR GB**

(71) Applicant: **Sumitomo Wiring Systems, Ltd.**
**1-14, Nishisuehirocho**
**Yokkaichi-shi Mie-ken(JP)**

(72) Inventor: **Goto, Yasufumi**
**1588-2, Noda**
**Iruma-shi(JP)**

(72) Inventor: **Tanaka, Takehiko**
**6-14, Midoricho-2-chome**
**Tokorozawa-shi(JP)**

(72) Inventor: **Sasaki, Kazuo**
**21-6, Sumiyoshi-2-chome**
**Suzuka-shi(JP)**

(72) Inventor: **Takashima, Hideaki**
**16, Sasagawa-9-chome**
**Yokkaichi-shi(JP)**

(72) Inventor: **Okano, Hironobu**
**4-15, Tenjincho-1-chome**
**Oyama-shi(JP)**

(72) Inventor: **Suzuki, Toshiyuki**
**1-11-6, Sekima**
**Sakado-shi(JP)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Wiring harness conduction testing apparatus.

(57) A conduction test apparatus capable of conducting an accurate conduction test of a wiring harness containing a diode ($D_1$, $D_2$), and a wiring harness conduction test apparatus capable of testing a plurality of wiring harnesses having connection wires less than the maximum chechable number of connection wires of the conduction test apparatus, continuously within the maximum checkable number of connection wires of the apparatus.

./...

Croydon Printing Company Ltd.

FIG. 6

The present invention relates to an apparatus for testing the wiring harness used with an automobile, electrical equipment, etc.

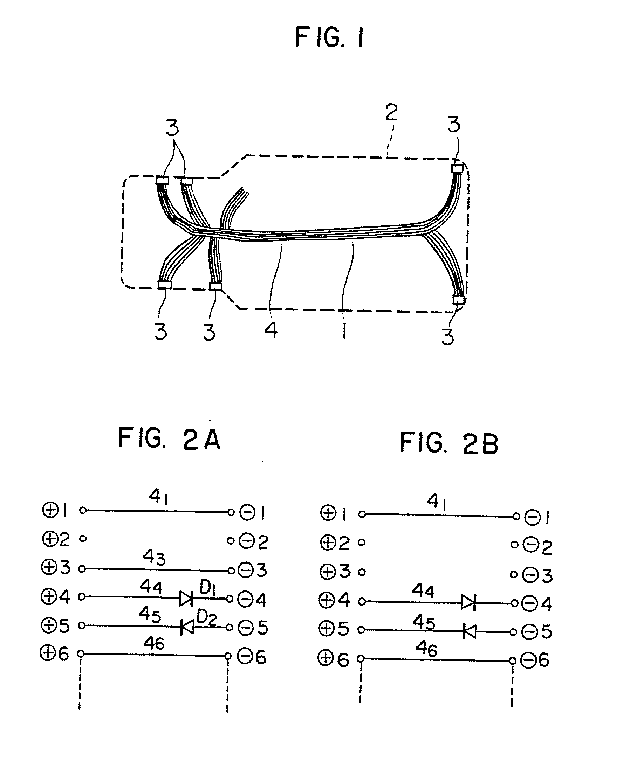

In a connector for connecting various devices such as the head light, tail light or other electrical devices to a power supply, or between different devices mounted in a car, what is called the wiring harness 1 arranged in accordance with the mounting positions of the devices is prepared in advance as shown in Fig. 1 and fixed in position on a car body 2 supplied on a conveyor belt, so that the input and output terminals thereof are connected by connectors 3 or like. In order to secure the reliability of a car, etc., it is important that the connection wires 4 be connected to the connectors in predetermined conditions in wiring harness arrangement. Nevertheless, the number of the connection wires 4 is ever on the increase with the improved performance of the cars, etc. As a result, it unavoidably occurs, though rarely, that as shown in Fig. 2A, for example, in spite of the need to connect the connector contact $(+)1$ to $(-)1$, contact $(+)3$ to $(-)3$ and so on by the independent connection wires $4_1$, $4_3$ and so on respectively with the contacts $(+)2$ and $(-)2$ left unconnected, an erroneous connection unavoidably occurs, though rarely, in which as shown in Fig. 2B, the contacts (+) and (-)3 are left unconnected.

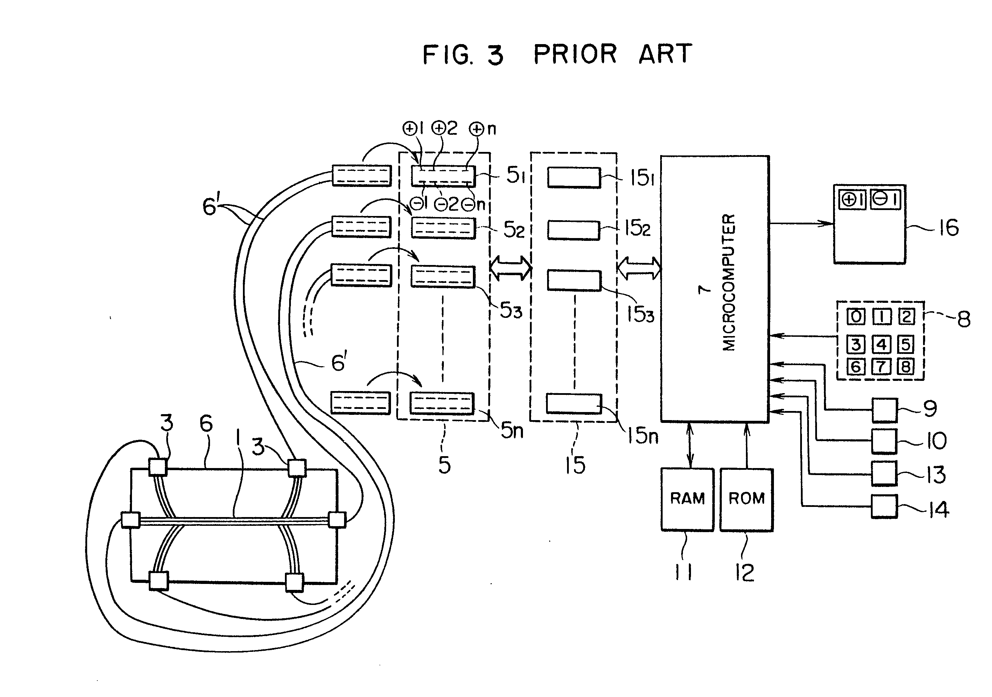

In order to discover such connection error and repair it automatically and rapidly, a conduction test apparatus commonly known as a wiring harness checker as shown in Fig. 3 is generally used.  This apparatus comprises:

(1) a group of connectors $5_1$, $5_2$, ..., $5_n$ in the same number as the test connector circuits including (+) and (-) contacts connected through test relay lines 6' respectively to the input and output terminals of the wiring harness 1 placed on a test table 6 and connected to connectors 5 arranged on the test table 6;

(2) a processing circuit 7 such as a microcomputer (hereinafter referred to as the "micom") 7, including a random access memory (RAM) 11 in which the depression of a key [1], for instance, of an address-designating keyboard 8 corresponding to the contact number of a contact followed by the depression of an independent connection key [9] designates the address 1 to make the connection "1", or the depression of the key [2], for instance, of the keyboard 8 followed by the depression of a no-wire key 10 designates the address 2, thereby setting the predetermined connection shown in Fig. 2A, and a read-only memory (ROM) 12 in which the address-designating keyboard 8 sets an operation control program for program step-up to supply a change-over command for a group of checking change-over circuits 15 described later and to collate the setting of the memory 11 with the output of the checking change-over circuits 15, the collation being started by a start key 13 and suspended temporarily upon occurrence of a trouble, the operation being restarted from the beginning upon depression of a restoration key 14;

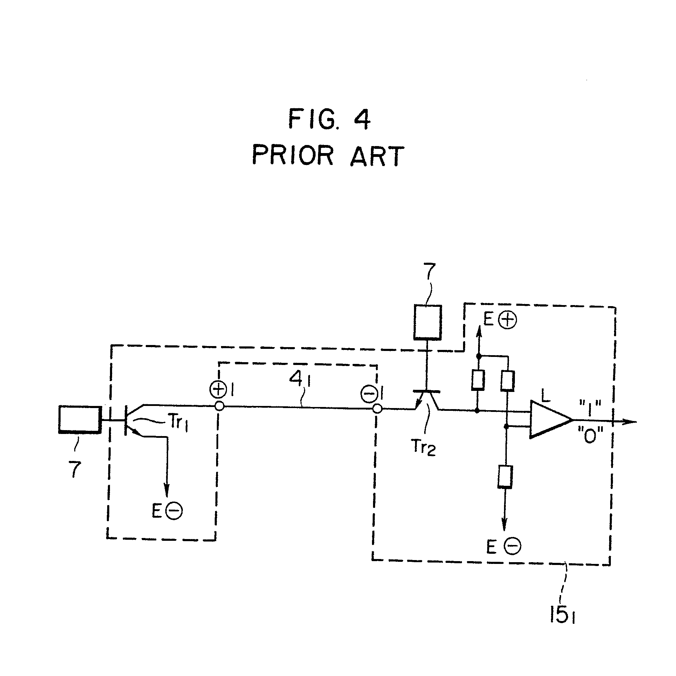

(3) the checking change-over circuits 15 including checking change-over circuits $15_1$, $15_2$, ..., $15_n$ each having, as shown in Fig. 4, a switching transistor $T_{r1}$ for connecting the positive contact of the connectors 5 to the negative terminal of a power supply E and a level detector L which connects the negative contact through a transistor $T_{r2}$ to the positive terminal of the power supply E while at the same time detecting the potential appearing at the negative contact as a "1" or "0" signal, wherein the switching transistors $T_{r1}$, $T_{r2}$ are so operated as to sequentially turn on the contacts (+)1, (-)1 and (+)2, (-)2 in that order by means of a switching signal from the micom 7 thereby to supply current to the respective connection wires, with the result that in the predetermined connection mode shown in Fig. 2A, a "1" signal is produced from the level detector L when the contacts (+)1 and (-)1 are connected and a "0" signal when the contacts (+)2, (-)2 and (+)3, (-)3 are not connected as shown in Fig. 2B; and

(4) an indication circuit 16 which is stepped in synchronism with the switching of the checking change-over circuits 15 by a command from the micom 7 to indicate an alarm for the (+) and (-) contacts sequencial- ly, and in which if the contacts (+)3 and (-)3 are not connected as shown in Fig. 2B resulting in the output "0" of the checking change-over circuit $15_3$ in spite of the requirement of normal connection by single wire between the contacts (+)3 and (-)3 as shown in Fig. 2A, the stepping operation is stopped by a command from the micom 7 which is stopped by collation, thus indicating the contact number associated with a trouble while at the same time issuing a trouble alarm sound.

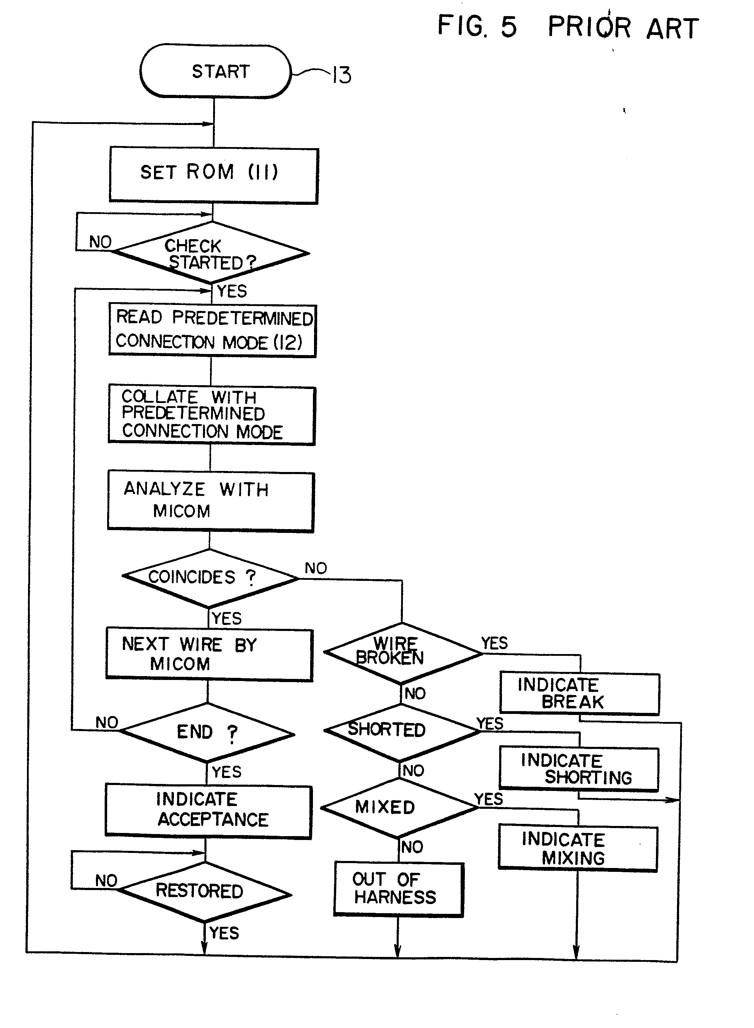

With these component devices, this conventional apparatus is for checking the conduction of the wiring harness by a series of decisions such as shown in Fig. 5.

In another conventional apparatus, the collation of the data set in the memory circuit for setting a predetermined connection mode with the output of the checking change-over circuit and the control of each circuit are effected not by the above-mentioned program but by a hardware circuit.

Regardless of whether software or hardware is used for collation, the checking change-over circuit of the conventional apparatuses is such that, as described above with reference to Fig. 4, current flows only in one direction in the connector circuit to be tested. In the case where an element such as a diode $D_1$ having the function of blocking the current is connected with the connection wire $4_4$ in the forward direction of

0164570

current as shown in Fig. 2A, for instance, the conduction check is possible. If a diode $D_2$ connected to the connection wire $4_5$ is reverse in direction, by contrast, current cannot be supplied. In the conventional testing apparatuses, therefore, the conduction of the wiring harness containing a diode cannot be checked.

The number of connection wires normally varies with the type of the car using the wiring harness. Generally, the wiring harness having the greatest number of connection lines is selected as an object of a conduction testing apparatus, so that the memory capacity of the memory circuit for setting a predetermined connection mode and the number of the checking change-over circuits are determined and are separately arranged for respective testing tables to check the conduction. In these conventional apparatuses, however, the operating efficiency is reduced in the case where the number of the connection wires of the wiring harness is smaller than the maximum test connection wires of the conduction testing apparatus.

Accordingly, it is an object of the present invention to provide a conduction testing apparatus which is capable of accurately conducting a conduction test on a wiring harness containing a diode.

Another object of the present invention is to utilize conduction test apparatuses effectively by making it possible to check a plurality of wiring harnesses by a single conduction test apparatus within

- 6 -

0164570

the scope of the maximum test connection wires thereof in the case where the wiring harness have connection wires smaller in number than the maximum test connection wires of the conduction test apparatus and are tested continuously.

The invention will be described in detail with reference to the accompanying drawings, in which:

Fig. 1 is a schematic diagram showing a wiring harness;

Figs. 2A and 2B are diagrams showing the internal connections of a wiring harness;

Fig. 3 is a diagram showing a conventional wiring harness conduction test apparatus;

Fig. 4 is a diagram showing a conventional checking change-over circuit;

Fig. 5 is a flow chart for a conventional wiring harness conduction test;

Fig. 6 is a diagram showing an embodiment of the present invention;

Fig. 7 shows an example of the programs stored in the memory;

Fig. 8 is a diagram showing a second embodiment of the present invention;

Figs. 9A and 9B are diagrams for explaining the setting of a memory for setting a predetermined connection mode and the distribution of checking change-over circuits using a distribution circuit; and

Figs. 10 and 11 are flow charts showing the operation of the memory circuit for setting an operation control program.

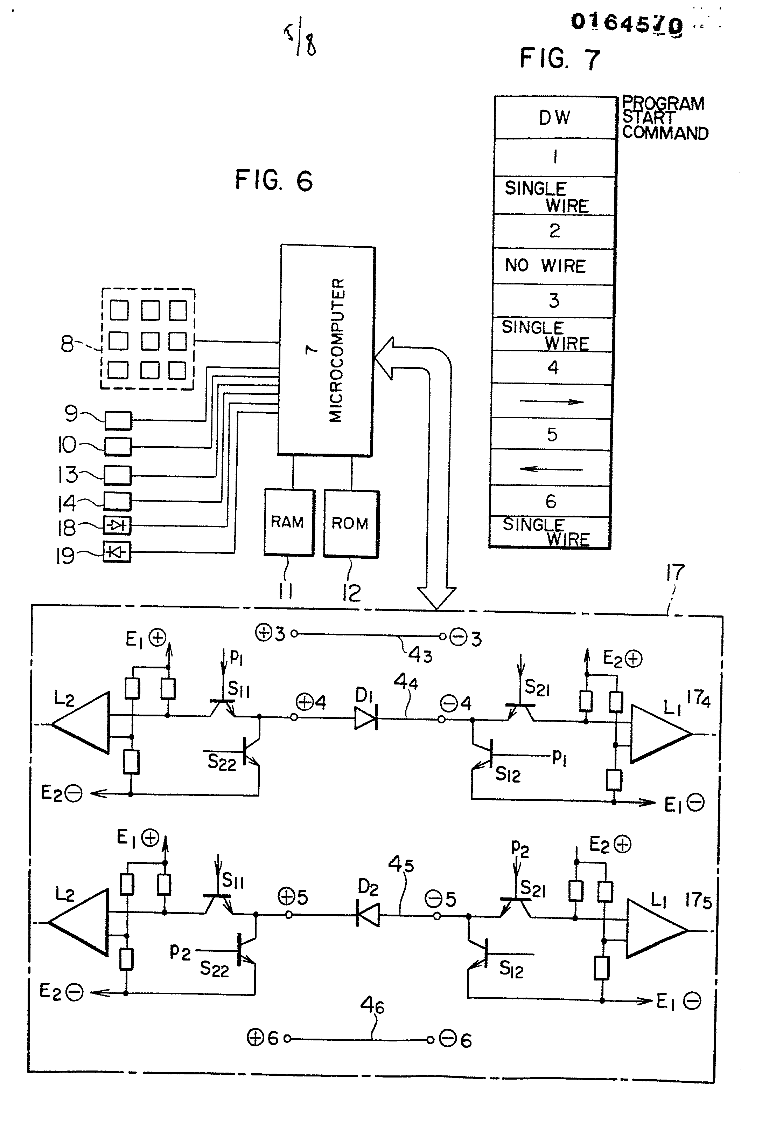

With reference to Fig. 6, reference numerals $4_3$, $4_4$, $4_5$, $4_6$, ... designate connection wires, $D_1$, $D_2$ diodes, numerals $17_4$, $17_5$, ... checking change-over circuits making up the essential parts of the present invention. Each of the checking change-over circuits is formed of the parts mentioned below and makes up a group of checking change-over circuits 17. Characters $S_{11}$, $S_{12}$ designate switching transistors for supplying current to a connector circuit to be tested from the positive contact to the negative contact thereof, and characters $S_{21}$, $S_{22}$ switching transistors for applying current to a connection wire circuit to be tested from the negative contact to the positive contact thereof. Characters $E_1$, $E_2$ designate power supplies, and characters $L_1$, $L_2$ level detectors. Numeral 7 designates a micom, numeral 11 a memory circuit for setting a predetermined connection mode, numeral 12 a memory circuit for setting an operation control program, numeral 8 a address-designating keyboard, numeral 9 a single-wire connection key, numeral 10 a no-wire key, and numerals 18, 19 keys for designating the direction of diode connection provided for explaining the present invention, including a forward designation key 18 and a reverse designation key 19. In the case where diodes $D_1$ and $D_2$ are connected as shown in Fig. 2A, for example, predetermined connection modes are written in the

- 8 -

connection mode-setting memory circuit 11 to check the connection of the wiring harness in accordance with a change-over command for changing one check change-over circuit $17_4$ to other circuit $17_5$. The change-over command is stored in the operation control program-setting memory circuit 12.

First, writing keys not shown are operated, and the key [1] on the address-designating keyboard 8 is depressed, followed by the depression of the single-wire connection key 9, key [2] of the keyboard 8, no-wire connection key 10, key [3] of the keyboard 8, single-wire connection key 9, key [4] of the keyboard 8, the diode forward designation key 18, single-wire connection key 9, key [5] of the keyboard 8, the diode reverse designation key and the single-wire connection key 9 in that order, thereby setting a predetermined connection mode as shown in Fig. 7. In starting the checking operation, a start key 13 is depressed. The switching transistors $S_{11}$, $S_{12}$ of the checking change-over circuit 17 for the contacts up to number (+)4 are turned on as the bases thereof are supplied with a change-over command signal $P_1$ by the instruction from the micom 7 based on the operation control program-setting memory circuit 12. Upon designation of the contact (+)4, a circuit is formed from the positive terminal of the power supply $E_1$ to switch $S_{11}$ to contact (+) to diode $D_1$ to contact (-) to switch $S_{12}$ to negative power supply, with the result that current is supplied to the connection wires from contacts (+) to (-) thereof. When the designation of contact number changes to (+)5, the change-over command signal $P_1$ from the micom 7 is replaced by $P_2$ which is applied to the switches $S_{21}$, $S_{22}$ of the checking change-over circuit 17 thereby to turn them on, thereby forming a circuit from the positive terminal of the power supply $E_2$ to switch $S_{21}$ to contact (-) to diode $D_2$ to contact (+) to switch $S_{22}$ to negative terminal of the power supply $E_2$ to supply current to the connection line $4_5$. When the contact signal changes to 6, the change-over command signal $P_2$ is again replaced by $P_1$ which is applied to the checking change-over circuit, so that current flows from contact (+) to contact (-) and the detectors $L_1$, $L_2$ detect the levels involved which are applied to the micom 7, thus collating the output of the checking change-over circuit 17 with the normal connection mode set in the memory circuit 11. In similar manner, current may be applied in reverse direction to detect that current is blocked.

It will be understood from the foregoing description of the first embodiment of the present invention, that even when an element having the function of blocking current such as a diode is inserted, a simple operation of setting a change-over command designating the polarity of diode connection set in the normal connection mode-setting memory circuit by depressing a key corresponding to the direction of diode connection makes it possible to check in the same manner as in the conventional apparatuses, thereby enlarging the checking functions of a conduction test apparatus.

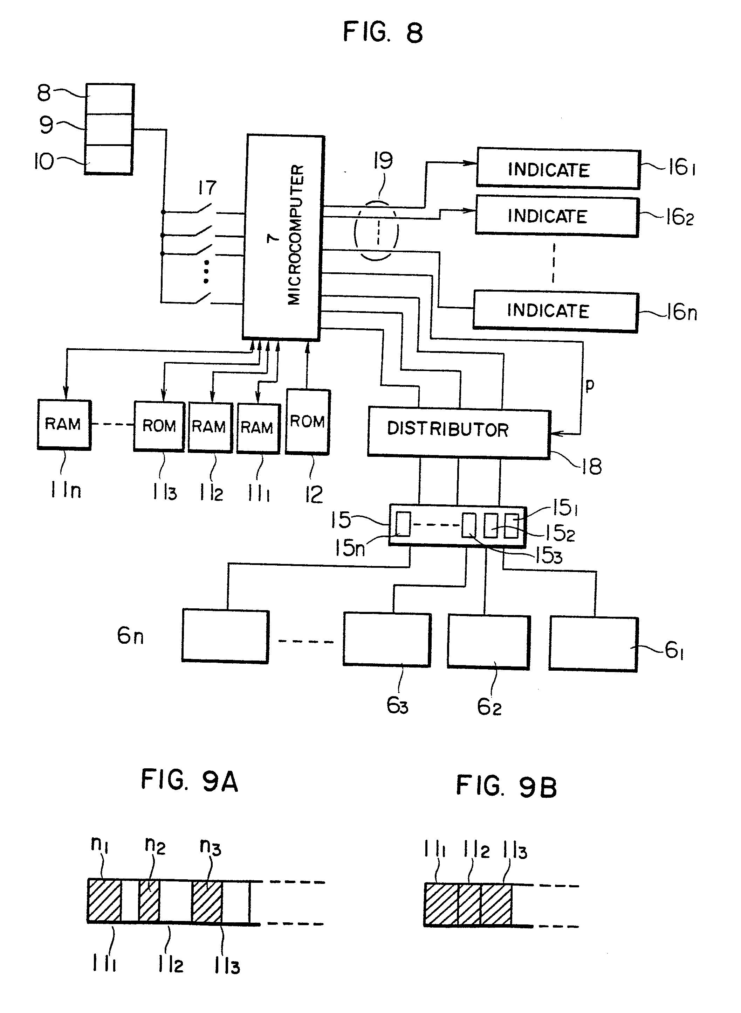

A second embodiment of the present invention will be explained with reference to Fig. 8. The features of this embodiment are described below. The first feature concerns the construction of the micom 7. Assuming that the maximum checkable number of connector circuits is N, the micom 7, as shown in Fig. 8, includes a number $n$ of predetermined connection mode-setting memory circuits $11_1$, $11_2$, ..., $11_n$ of the same memory capacity and an operation control program-setting memory circuit 12. In addition, a number $n$ of memory selection keys 17 as many as the predetermined connection mode-setting memory circuits are provided and operated to set predetermined connection modes for a wiring harness independently in the predetermined connection mode-setting memory circuits $11_1$, $11_2$, ..., $11_n$ respectively by way of a setting key board 8, a single-wire key 9, a no-wire key 10, etc.

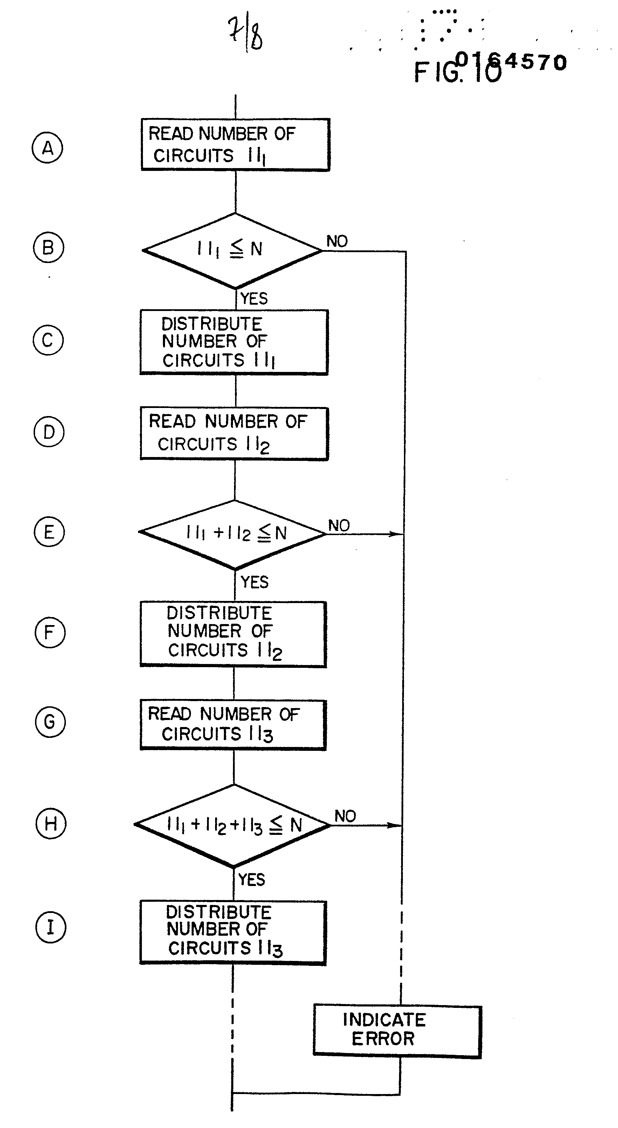

A second feature of the second embodiment of the invention is a distributor circuit 18 including a number N of gate circuits where N is the number of maximum checkable connection wires, in which a number N of checking change-over circuits $15_1$, $15_2$, ..., $15_n$ of the checking change-over circuit 15 are distributed among the normal connection mode-setting memory circuits $11_1$, $11_2$, ..., $11_n$ as shown in Fig. 9B for the numbers

...

- 11 -

of test connection line circuits $n_1$, $n_2$, ..., $n_n$ of
Fig. 9A set in the predetermined connection mode-setting
memory circuits $11_1$, $11_2$, ..., $11_n$ in the manner
mentioned above, by a command signal $P_1$ supplied on
the basis of a program described later set in the
operation control program-setting memory circuit 12.
This distributor circuit 18 includes a circuit for
comparing the output of each checking change-over circuit
with the data set in each normal connection mode-setting
memory circuit $11_1$, $11_2$, ..., $11_n$ each time of program
step-up by the operation control program-setting
memory circuit 12. In other wores, the operation
control program-setting memory circuit 12 has the functions shown in the flow chart of Fig. 10 including

(A) reading the set number $n_1$ of the connector
circuits of the normal connection mode-
setting memory circuit $11_1$;

(B) collating the maximum number N of connector
circuits with the number of circuits $n_1$;

(C) supplying a distribution command signal to
the distributor circuit 18 in the case
where $11_1$ is smaller than N; and

(D) reading the set number $n_2$ of the connector
circuits of the predetermined connection
mode-setting memory circuit $11_2$;

(E) deciding whether $11_1 + 11_2 \leq N$; and

(F) supplying a distribution command signal
to the distributor circuit when $11_1 +$

$11_2 \leq N.$

Subsequently, the comparing operations are performed in the same manner sequentially for distribution. On the other hand, a program is set for supplying an error signal indicating the impossibility of checking when the maximum number of distributor circuits processed exceeds the maximum number N of checkable connection wires in the collation process to perform the above-mentioned distributing operation.

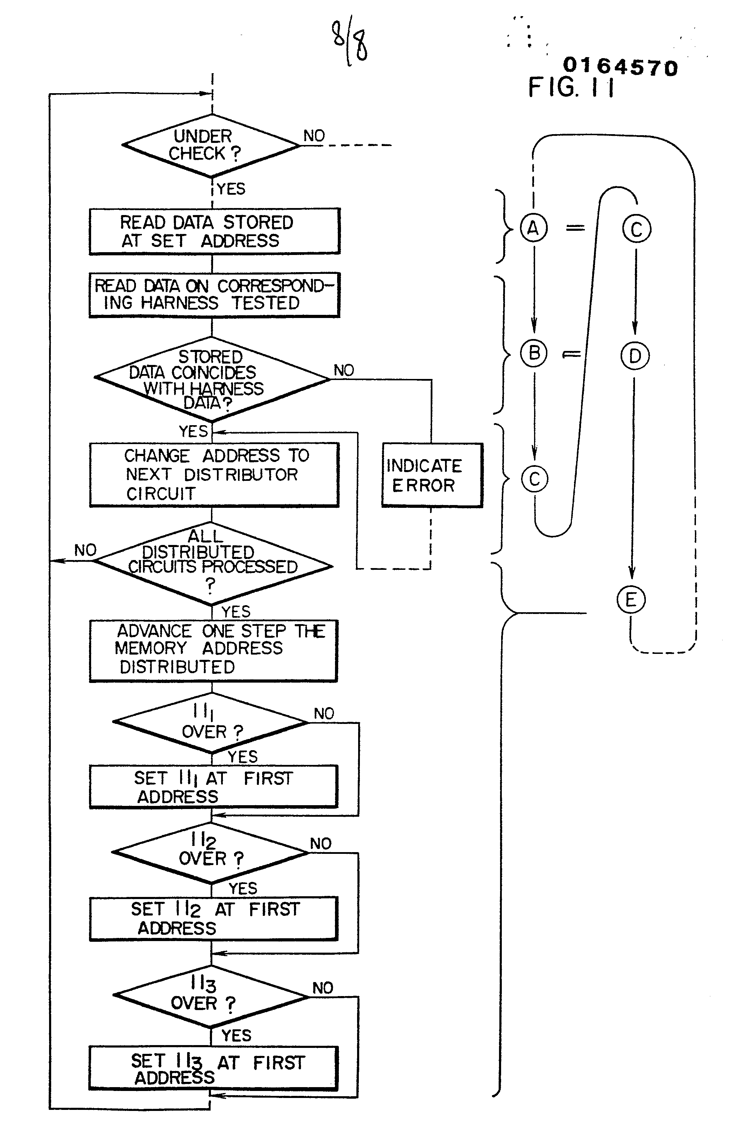

A third feature of the second embodiment of the present invention lies in that the program as described below is set in the operation control program-setting memory circuit 12 for collating the data set in the predetermined connection mode-setting memory circuits $11_1$, $11_2$, ..., $11_n$ with the outputs of the checking change-over circuits 15 distributed. Specifically, as shown in the flow chart of Fig. 11, the program functions to

(A) read the data at the first address set in the normal connection mode-setting memory circuit $11_1$;

(B) collate the data read at the address with the output of the corresponding checking change-over circuit;

(C) read the data at the first address set in the predetermined connection mode-setting memory $11_2$;

0164570

(D) collate the data of the memory $11_2$ with the output of the checking change-over circuit, followed by similar collating operations for the predetermined connection mode-setting memory circuits;

(E) when no abnormality is involved, step up the program by one step and sequentially read the data at the second address of each of the predetermined connection mode-setting memory circuits $11_1$, $11_2$, ..., $11_n$; and

(F) collate the data read at the address with the output of the checking change-over circuit.

A fourth feature of the second embodiment of the present invention is an indication circuit 16 including indication circuits $16_1$, $16_2$, ..., $16_n$ in the same number as the normal connection mode-setting memory circuits, which are connected to the micom 7 by cables 19 of a length sufficient to reach test tables $6_1$, $6_2$, ..., $6_n$ located at a distance from the conduction test apparatus and are respectively stepped forward to sequentially indicate the numbers of contact (+) and contact (-) by a signal supplied from the operation control program-setting memory circuit 12 each time of step-up of the program in the predetermined mode-setting memory circuits $11_1$, $11_2$, ..., $11_n$. The

indication circuits $16_1$, $16_2$, ..., $16_n$ start to be stepped forward by the signal supplied at the time of reading the data at the first address of the respective normal connection mode-setting memory circuits $11_1$, $11_2$, ..., $11_n$.

A fifth feature of the second embodiment of the present invention lies in that a start key and a restoration key are provided for each of the indication circuits $16_1$, $16_2$, ..., $16_n$. The start key is operated to start the micom 7 and the steping forward operation of the indication circuit 16, while the restoration key is used to update the indication on the indication circuit 16 and to cut off the step-forward circuit to operate the conduction test apparatus remotely.

In the case where one of the test tables is connected with a wiring harness and the start key associated therewith is depressed, for instance, only an indication associated with the start key is actuated for checking. If another start key is depressed with another wiring harness connected during the checking, the wiring harness is checked simultaneously with the one first connected. When the restoration key is depressed upon completion of the check of the first wiring harness, a wiring harness subsequently connected, is checked. In this way, a succession of wiring harnesses connected are checked.

In the manner mentioned above, a single conduction test apparatus may be used for checking a

0164570

plurality of wiring harness within the scope of the maximum number of checkable connector circuits, thereby improving the operating efficiency by saving the checking ability of the conduction test apparatus. Further, according to the second embodiment of the present invention, a plurality of wiring harnesses can be checked by use of a single conduction test apparatus, and that, wiring harnesses having different numbers of connector circuits can be checked independently of each other. This eliminates the effect of the check of an operator which otherwise might have on the checking of a different operator, thereby improving the efficiency of the checking work.

0164570

1. A wiring harness conduction test apparatus comprising:

a processing circuit (7) including an operation control program-setting memory circuit (12) and a memory circuit (11) for storing predetermined connection modes of wiring harness connection circuits;

a plurality of checking change-over circuits $(15_1, 15_2, 15_3, ..., 15_n)$ for supplying current sequentially to the individual connection wires of the wiring harness in accordance with an output signal of said processing circuit (7) and producing a signal indicating the connection of said wiring harness, said current being capable of being supplied in selected one of the positive and negative directions of the connection wires; and

means for comparing an output signal of said checking change-over circuits with a predetermined connection mode stored in said memory circuit (11) and deciding whether the connection of said wiring harness coincides with said predetermined connection mode.

2. A wiring harness conduction test apparatus according to Claim 1, wherein said checking change-over circuits includes first and second change-over switches $(S_{11}, S_{12}, S_{21}, S_{22})$ and first and second power supplies $(E_1; E_2)$ adapted to be connected to one of the terminals of the connection wires to be tested, by switching of the first and second change-over switches, and a current-blocking element $(D_1, D_2)$, said operation control

program-setting memory circuit (12) having the function of supplying a command signal for switching the first and second change-over switches $(S_{11}, S_{12}, S_{21}, S_{22})$

in such a manner as to supply current in accordance with the polarity of the current-blocking element $(D_1,$

$D_2)$.

3.       A wiring harness conduction test apparatus comprising: a processing circuit (7) including an operation control program-setting memory circuit (12) and a plurality of memory circuits $(11_1, 11_2, 11_3, \ldots,$

$11_n)$ for storing predetermined connection modes of wiring harness connector circuits, said processing circuit including a plurality of selection keys in the same number as said predetermined connection mode

memory circuits $(11_1, 11_2, 11_3, \ldots, 11_n)$ for switching

an address-setting keyboard (8), a single-wire key (9),

a no-wire key (10) by use of which predetermined connection modes can be set independently;

a plurality of checking change-over circuits

$(15_1, 15_2, 15_3, \ldots, 15_n)$ for applying current

sequentially to the individual connection wires of said wiring harness in accordance with an output signal of said processing circuit (7) thereby to produce a signal indicating the connecting condition of said wiring harness;

means for comparing an output signal of said checking change-over circuits $(15_1, 15_2, 15_3, \ldots, 15_n)$

with a predetermined connection mode stored in said

memory circuits $(11_1, 11_2, 11_3, ..., 11_n)$ in accordance with an output signal of said processing circuit (7), and deciding whether the connecting condition of said wiring harness coincides with said predetermined connection mode; and a plurality of indication circuits $(16_1, 16_2, ..., 16_n)$ for indicating the positions of any connection wires of the wiring harness not coincident with said predetermined connection mode, said indication circuits including a start key (13) and a restoration key (14) connected through cables to corresponding ones of said predetermined connection mode-setting memory circuits $(11_1, 11_2, 11_3, ..., 11_n)$ respectively; and

a distributor circuit (18) for distributing said wiring harness circuit including said checking change-over circuits $(15_1, 15_2, ..., 15_n)$ among said predetermined connection mode-setting memory circuits $(11_1, 11_2, 11_3, ..., 11_n)$ by said operation control program-setting memory circuit (12) thereby to collate an output of said distributed checking change-over circuits produced by said processing circuit with the data set in the predetermined connection mode-setting memory circuits, wherein the checking change-over circuits distributed by said distributor circuit are switched, and the output of the checking change-over circuits is collated with the data set in the predetermined connection mode-setting memory circuits, serially for each address of the predetermined connection mode-setting memory circuits according to a program

0164570

executed by the operation control program-setting memory circuit (12).

0164570

## FIG. 1

## FIG. 2A

## FIG. 2B

# FIG. 3  PRIOR ART

# FIG. 4
## PRIOR ART

4/8

0164570

## FIG. 5  PRIOR ART

```
        ( START )─── 13
             │
             ▼
     ┌───────────────┐
     │  SET ROM (11)  │
     └───────────────┘
             │
             ▼
NO ◄──◇ CHECK
        STARTED? ◇
             │ YES
             ▼
  ┌──────────────────┐
  │ READ PREDETERMINED│
  │ CONNECTION MODE(12)│
  └──────────────────┘
             │
             ▼
  ┌──────────────────┐
  │ COLLATE WITH      │
  │ PREDETERMINED     │
  │ CONNECTION MODE   │
  └──────────────────┘
             │
             ▼
  ┌──────────────────┐
  │ ANALYZE WITH      │
  │ MICOM             │
  └──────────────────┘
             │
             ▼
      ◇ COINCIDES ? ◇──── NO
             │ YES
             ▼
  ┌──────────────────┐        ◇ WIRE    ◇──── YES
  │ NEXT WIRE BY     │          BROKEN
  │ MICOM            │             │ NO
  └──────────────────┘
             │
NO ◄──◇  END ? ◇              ◇ SHORTED ◇──── YES
             │ YES
             ▼
  ┌──────────────────┐        ◇ MIXED  ◇──── YES
  │ INDICATE         │             │ NO
  │ ACCEPTANCE       │
  └──────────────────┘        ┌──────────────┐
             │                │ OUT OF       │
NO ◄──◇ RESTORED ◇            │ HARNESS      │
             │ YES            └──────────────┘
             ▼

  ┌──────────────┐
  │ INDICATE     │
  │ BREAK        │
  └──────────────┘

  ┌──────────────┐
  │ INDICATE     │
  │ SHORTING     │
  └──────────────┘

  ┌──────────────┐
  │ INDICATE     │
  │ MIXING       │
  └──────────────┘
```

FIG. 6

FIG. 7

| DW | PROGRAM START COMMAND |
|---|---|
| I | |
| | SINGLE WIRE |
| 2 | |
| | NO WIRE |
| 3 | |
| | SINGLE WIRE |
| 4 | |
| | → |
| 5 | |
| | ← |
| 6 | |
| | SINGLE WIRE |

FIG. 8

FIG. 9A

FIG. 9B

FIG. 10

0164570

(A) — READ NUMBER OF CIRCUITS $11_1$

(B) — $11_1 \leqq N$  — NO →

YES

(C) — DISTRIBUTE NUMBER OF CIRCUITS $11_1$

(D) — READ NUMBER OF CIRCUITS $11_2$

(E) — $11_1 + 11_2 \leqq N$ — NO →

YES

(F) — DISTRIBUTE NUMBER OF CIRCUITS $11_2$

(G) — READ NUMBER OF CIRCUITS $11_3$

(H) — $11_1 + 11_2 + 11_3 \leqq N$ — NO →

YES

(I) — DISTRIBUTE NUMBER OF CIRCUITS $11_3$

INDICATE ERROR

8/8

0164570

FIG. 11